# EUROPEAN PATENT APPLICATION

(11) **EP 1 993 338 A1**
(43) Date of publication of application: **19.11.2008**
(21) Application number: 07738017.8
(22) Date of filing: 08.03.2007
(51) Int. Cl.: H05K 9/00, B32B 15/08, G02B 1/10

(54) **PROCESS FOR PRODUCING TRANSLUCENT ELECTROMAGNETIC WAVE SHIELDING MATERIAL, TRANSLUCENT ELECTROMAGNETIC WAVE SHIELDING MATERIAL AND DISPLAY FILTER**

(30) Priority: 09.03.2006 JP 2006063908; 09.03.2006 JP 2006063919; 09.03.2006 JP 2006063929
(71) Applicant: Bridgestone Corporation, Tokyo 104-0031 (JP)
(72) Inventor: KOTSUBO, Hidefumi, Tokyo 187-8531 (JP); FUNAKI, Tatsuya, Tokyo 187-8531 (JP); SASAKI, Kiyomi, Tokyo 187-8531 (JP)
(74) Representative: Whalley, Kevin
(86) International application number: PCT/JP2007/054526
(87) International publication number: WO 2007/102577

(57) **Abstract**

The present invention provides a process for preparing the light transmissive electromagnetic wave shielding material having an enhanced productivity.

A process for preparing a light transmissive electoromagnetic shielding material comprising;
coating a transparent substrate with a pretreatment agent for electroless plating comprising a noble metal compound and a mixture of silane coupling agent and azole compound or a reaction product thereof to form a coated layer and drying the coated layer to provide a pretreatment layer on the transparent substrate,
forming a plating protective layer in the dot pattern on the pretreatment layer, and
subjecting the exposing part of the pretreatment layer having no plating protective layer to electroless plating to form a metal conductive layer in the mesh pattern.

## Description

### Background of Invention

### 1. Field of the invention

The present invention relates to a process for preparing a light transmissive electromagnetic wave shielding material which is useful in an adhesive sheet which can be used for a front filter of a plasma display panel (PDP) or windows of a building such as a hospital requiring electromagnetic wave shielding. In addition, the invention relates to an electromagnetic wave shielding material prepared by the above process and a display panel provided with the material.

### 2. Description of the Related Art

In recent years, as office automation equipments and communication equipments have become increasingly popular, there is fear that an electromagnetic wave generated by the equipments has an affect on the human body. In addition, the electromagnetic wave generated by a cell-phone may cause a precision equipment to malfunction. Therefore, the occurrence of the electromagnetic wave is of a problem to be solved.

For the reason, a light transmissive electromagnetic wave shielding material having a light transmissive property and an electromagnetic wave shielding property had been developed as a front filter of a plasma display panel and are put to practical use. Also the light transmissive electromagnetic wave shielding material is used as a window filter of a hospital and a laboratory where the precision equipment is installed in order to protect the precision equipment from the electromagnetic wave.

The light transmissive electromagnetic wave shielding material is required to balance the light transmissive property with the electromagnetic wave shielding property. Therefore, the light transmissive electromagnetic wave shielding material adopts, for example a conductive layer having a fine mesh structure. The mesh part of the conductive layer can shield electromagnetic wave and the opening part of it can ensure light transmissive property.

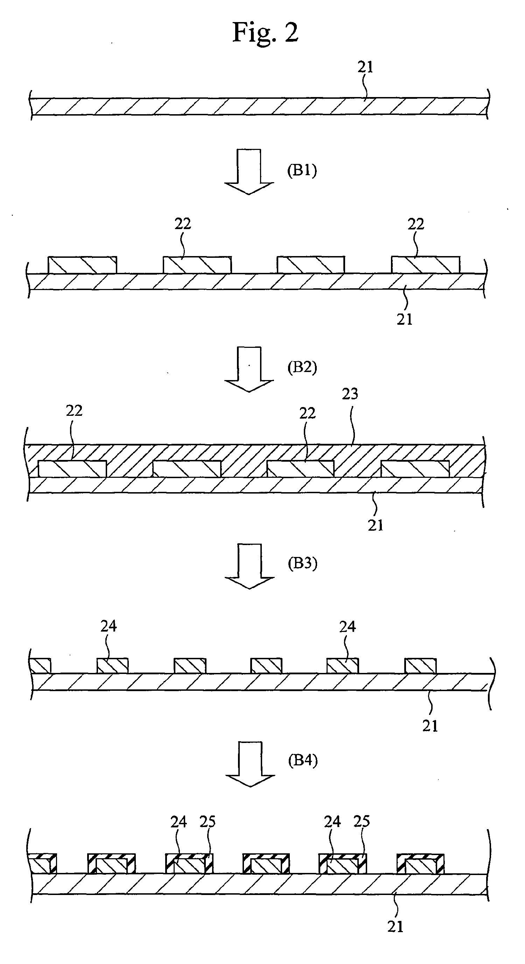

The light transmissive electromagnetic wave shielding material can be prepared by various processes. A preferable process for preparing it is shown in Fig. 2. First, a water-soluble ink 22 is printed on a transparent substrate 21 to provide a negative pattern of a mesh structure (printing step; an arrow B 1 of Fig. 2). Copper is deposited thinly on the negative pattern to provide a thin film 23 comprising copper (depositing step; an arrow B2 of Fig. 2). The water-soluble ink 22 is subsequently washed out to provide a metal conductive layer 24 having the mesh structure (washing step; an arrow B3 of Fig. 2). Such process is disclosed in patent document 1.

This process can narrow the line width of the metal conductive layer of the light transmissive electromagnetic wave shielding material and increase the aperture ratio of it. However, the thickness of the metal conductive layer obtained by the process becomes to be small. Therefore, in order to provide the preferred conductive property to the light transmissive electromagnetic wave shielding material, the metal conductive layer 24 is coated preferably with copper by electrolytic plating to provide a copper layer 25 having a sufficient thickness (plating step; an arrow B4 of Fig. 2).

The light transmissive electromagnetic wave shielding material prepared by the above process has a metallic luster generated on a surface of the copper layer (the metal conductive layer). When the light transmissive electromagnetic wave shielding material is used in a front panel of PDP, the surface of the metal conductive layer causes the bright glare by reflecting external light. For use the light transmissive electromagnetic wave shielding material in the front panel of PDP, a blackening step is carried out generally to provide an anti-glare property. The surface of the metallic copper layer is subjected to an oxidation treatment or a sulfurization treatment to provide a blackening treatment layer having the anti-glare property (blackening treatment step).
Patent Document 1: JP-A-2001-332889

### Summary of the Invention

According to the conventional process, the light transmissive electromagnetic wave shielding material is prepared through many steps, for example, the printing step, the depositing step, the washing step, the plating step, and if necessary a blackening treatment step. However, there is demand to enhance a productivity of the light transmissive electromagnetic wave shielding material, therefore, it is necessary to improve the productivity by reduction of the steps or deletion of the depositing step.

Accordingly, the object of the present invention is to provide a process for preparing the light transmissive electromagnetic wave shielding material having an enhanced productivity, for example, by reduction of the steps or deletion of the depositing step.

### Effect of the Invention

The study of the present inventors reveals that the above object can be resolved by forming a metal conductive layer on a transparent substrate by electroless plating with a pretreatment agent for electroless plating comprising a noble metal compound and a mixture of silane coupling agent and azole compound or a reaction product thereof.

Accordingly, the present invention can resolve the above object by a process for preparing a light transmissive electromagnetic wave shielding material comprising;
coating a transparent substrate with a pretreatment agent for electroless plating comprising a noble metal compound and a mixture of silane coupling agent and azole compound or a reaction product thereof to form a coated layer and drying the coated layer it to thereby provide a pretreatment layer on the transparent substrate,
forming a plating protective layer in a dot pattern on the pretreatment layer, and
subjecting the exposing part of the pretreatment layer having no plating protective layer to electroless plating to form a metal conductive layer in the mesh pattern.

The preferred embodiments of the process for preparing a light transmissive electromagnetic wave shielding material according to the present invention are set forth below;
(1) The silane coupling agent is an epoxy-containing silane compound.
(2) The silane coupling agent is γ-glycidoxypropyltrialkoxysilane.
(3) The azole compound is imidazole.
(4) The noble metal compound is a compound containing at least one metal atom selected from the group consisting of palladium, silver, platinum and gold.
(5) The pretreatment agent for electroless plating further comprises a synthetic resin.
(6) The the synthetic resin has glass transition temperature of from -20 to 50 °C.
(7) The synthetic resin is at least one selected from the group consisting of polyester resin, polyurethane resin, acrylic resin and polyvinyl acetate resin.
(8) The pretreatment agent for electroless plating further comprises a polyfunctional isocyanate compound having two or more isocyanate groups.
(9) The process further comprises;
   subjecting a side of the transparent substrate to be formed the pretreatment layer to an easy adhesion imparting treatment before the step for forming the pretreatment layer.
(10) The easy adhesion imparting treatment is carried out by forming an easy adhesion layer comprising at least one oxide of metal selected from the group consisting of Si, Ti, Sn, Al and Zn on the transparent substrate.
(11) The easy adhesion imparting treatment is carried out by coating the transparent substrate with a solution comprising a synthetic resin and drying it to provide an easy adhesion layer.
(12) The easy adhesion imparting treatment is carried out by subjecting the transparent substrate to a corona treatment or a plasma treatment.
(13) The drying temperature is from 80 to 160 °C in the steps for forming the pretreatment layer on the transparent substrate.
(14) The plating protective layer comprises at least one selected from the group consisting of an acrylic resin, a polyester resin, a vinyl chloride resin and a styrene resin.
(15) The metal conductive layer comprises silver, copper or aluminum.
(16) The process further comprises;
   subjecting the metal conductive layer to a blackening treatment to form a blackening treatment layer on at least one part of a surface of the metal conductive layer.

### Brief Description of the Drawings

Fig. 1 is a view for explaining the process for preparing the light transmissive electromagnetic wave shielding material according to the present invention using cross-section views of each step.
Fig. 2 is a view for explaining the process for preparing the light transmissive electromagnetic wave shielding material according to the conventional technology using cross-section views of each step.

### Description of the reference numbers

11: transparent substrate
12: pretreatment layer
13: plating protective layer
14: metal conductive layer
15: blackening treatment layer
21: transparent substrate
22: water-soluble ink
23: thin film of copper
24: metal conductive layer
25: thin film of copper

### Detailed Description of the Invention

The process of the present invention comprises basically following steps;
forming the pretreatment layer on the transparent substrate by using the specific pretreatment agent for electroless plating,
forming a plating protective layer in a dot pattern on the pretreatment layer, and
forming a metal conductive layer on the exposing part of the pretreatment layer without forming the plating protective layer.

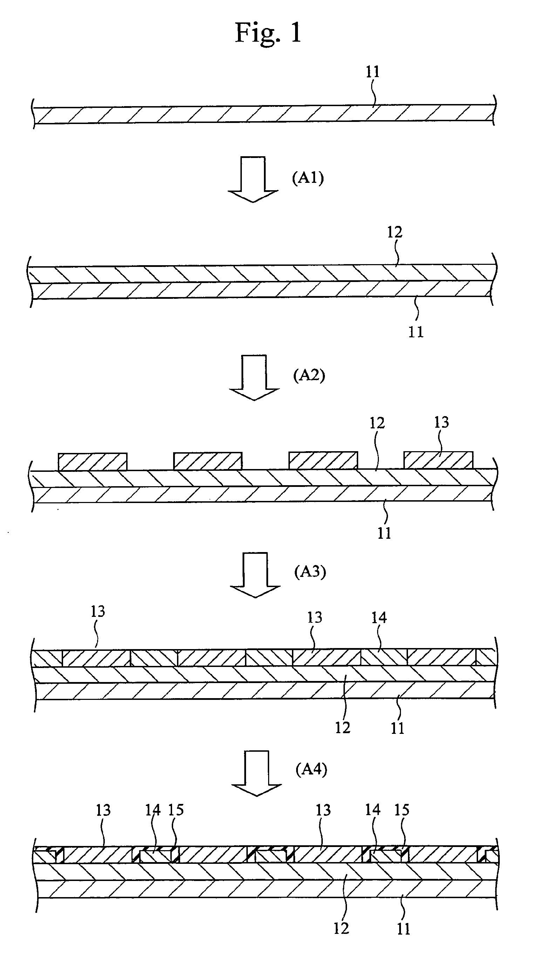

Each of the steps of the process of the present invention is shown by Fig. 1 showing the outline cross-section view. In the present invention, first, the pretreatment agent comprising a noble metal compound and a mixture of a silane coupling agent and an azole compound or a reaction product thereof is coated on the transparent substrate 11 and dried to provide the pretreatment layer 12 on the transparent substrate 11 (an arrow Al of Fig. 1). The pretreatment agent for electroless plating comprises the silane coupling agent, the azole compound and the noble metal compound, whereby the adhesion of the transparent substrate to the metal conductive layer can be improved, and the noble metal compound used as electroless plating catalyst in the pretreatment layer can be dispersed at the atomic level. As a result, the pretreatment layer is more transparent than a layer obtained by using noble metal particles as an electroless plating catalyst. In a conventional electroless plating method, the electroless plating catalyst is phisically absorbed to a surface roughed by contact with chromic acid. Therefore, in the conventional method, the transparent substrate is not only limited to an easily-roughed substrate, but also the substrate is apt to become untransparent owing to the granulous electroless plating catalyst. Also, a catalytic paint comprising the electroless plating catalyst used in the conventional electrolytic plating is similarly untransparent, because the paint comprises a metal or metal compound acting as a catalyst in the form of particle. Therefore, the substrate coated with the paint become untransparent and cannot be used in the process of the present invention. In contrast, the pretreatment agent of the present invention has excellent transparency, excellent catalytic activity and excellent adhesiveness without roughing the surface of the substrate by using coupling agent. In addition, there is no need to use the easily-roughed substrate.

In the present invention, the plating protective layer 13 having the dot pattern is subsequently formed on the pretreatment layer 12 (an arrow A2 of Fig. 1). The plating protective layer is formed to keep the specific part (i.e., dot pattern) of the pretreatment layer 12 free from influence of the electroless plating at a later step for forming the metal conductive layer 14 by electroless plating. The plating protective layer having the dot pattern is numerously formed on the pretreatment layer, so that the metal conductive layer can be formed on the space between the dots of the plating protective layer. In addition, the plating protective layer 13 can form the opening part of the metal conductive layer 14, thereby forming the metal conductive layer 14 in the mesh pattern.

In the present invention, the metal conductive layer is then formed on the exposing part of the pretreatment layer without forming the plating protective layer by electrolytic plating so as to have the mesh pattern (an arrow A3 of Fig. 1). The fine metallic particles are deposited continuously at high concentrations on the pretreatment layer exposing between the numerous dots of plating protective layer and around it to form the metal conductive layer binded firmly to the pretreatment layer. In addition, the metal conductive layer formed by electroless plating has a sufficient thickness and can be easily formed, whereby the manufacturing efficiency can be improved.

Accordingly, the present invention provides the process for preparing the light transmissive electromagnetic wave shielding material wherein it is not necessary to use the easily-roughed substrate in stead of the transparent substrate, and light transmissive property, electromagnetic property and manufacturing efficiency can be improved.

The process for preparing the light transmissive electromagnetic wave shielding material according to the present invention is explained in detail below.

In the present invention, firstly, the pretreatment agent comprising a noble metal compound and a mixture of silane coupling agent and azole compound or a reaction product is coated on the transparent substrate to form a coated layer and the coated layer is dried to provide the pretreatment layer on the transparent substrate.

The pretreatment layer may be formed on at least part of the transparent substrate where the metal conductive layer must be formed. However, the pretreatment layer is preferably formed on the whole surface of the transparent substrate.

Although the pretreatment agent for electroless plating may be prepared by simply mixing the silane coupling agent and the azole compound, these may be reacted preliminarily to form the reaction product thereof. The reaction product can disperse the noble metal compound in the pretreatment layer at the atomic level, whereby the light transmissive property of the obtained pretreatment layer can be improved.

In the reaction of the silane coupling agent with the azole compound, it is preferred to react the silane coupling agent in an amount of 0.1 to 10 mole per a mole of the azole compound at a temperature of 80 to 200 °C with a reaction time of 5 minutes to 2 hours. At the reaction, the solvent is not necessary. However, it is possible to use as the solvent water, an organic solvent such as chloroform, dioxane-methanol and ethanol. The pretreatment agent can be obtained by mixing the obtained reaction product of the silane coupling agent and the azole compound with the noble metal compound.

The silane coupling agent which can be used in the pretreatment agent preferably have a group having a metal capture ability. Such the silane coupling agent is capable of converting the electron state and arrangement of the noble metal compound used as the electroless plating catalyst to those showing increase catalytic activity of the metal and firmly bounding to the transparent substrate.

The silane coupling agent includes an epoxy-containing silane com-compound. Examples of the epoxy-containing silane compounds include, for example γ-glycidoxypropyltrialkoxysilane, 3-glycidoxypropyltrimethoxysilane, 3-glycidoxypropylmethyl dimethoxysilane, 3-glycidoxypropyltriethoxysilane, 3-glycidoxypropylmethyldiethoxysilane and 2-(3,4-epoxycyclohexyl)ethyltrimethoxysilane. These can be each used singly, or in combination of two more kinds. The γ-glycidoxypropyltrialkoxysilane is particularly preferred, because it gives a high light transmissive property to the obtained pretreatment layer,

Other examples of the silane coupling agents include γ-aminopropyltrimethoxysilane, γ-aminopropyltriethoxysilane, N-β-(aminoethyl)-γ-aminopropyltrimethoxysilane, N-β-(aminoethyl)-γ-aminopropyltriethoxysilane, and γ-mercaptopropyltrimethoxysilane.

Examples of the azole compounds which can be used in the pretreatment agent for electroless plating include imidazole, oxazole, thiazole, selenazole, pyrazole, isooxazole, isothiazole, triazole, oxadiazole, thiadizole, tetrazole, oxatriazole, thiatriazole, bendazole, indoazole, benzimidazole, benzotriazole and indazole. The imidazole is particularly preferred, because it has a high reactivity to the groups of the silane coupling agent such as epoxy group, and the noble metal compound.

The noble metal compound which can be used in the pretreatment agent is capable of selectivity precipitating the metal (for example copper and aluminum) from the plating solution and growing it. The noble metal compounds containing palladium, silver, platinum and gold are preferable, because they show high catalytic activity. Examples of the compounds include a chloride, a hydroxide, an oxide, a hydrosulfate and an ammine complex such as ammonium salt of the above metals. The palladium compound, in particularly the palladium choloride is preferred.

The pretreatment agent for electroless plating contains the noble metal compound in the amount of preferably 0.001 to 50 mol%, more preferably 0.1 to 20 mol% based on the azole compound and silane coupling agent. When the amount of the noble metal compound is less than 0.001 mol%, the catalyst activity is apt not to be high enough to form the metal conductive layer having thick sufficiently. When the amount of the noble metal compound is more than 50 mol%, the catalyst activity of the noble metal compound is apt not to be increased with the increase of the additive amount.

The pretreatment agent for electroless plating further preferably comprises a synthetic resin. The pretreatment layer containing the synthetic resin can adhere firmly to the plating protective layer and the metal conductive layer. It is, therefore, possible to prevent the detachment of the plating protective layer and the metal conductive layer.

The synthetic resin contained in the plating agent for electroless plating preferably includes a resin having a glass transition temperature in the range of -20 to 50 °C, in particular -10 to 20 °C. The resin prevents a blocking phenomenon between the pretreatment layer and the plating protective layer or the metal conductive layer to improve the adhesion of those.

In the present invention, the glass transition temperature is a temperature of the maximum value of loss tangent (tan δ) determined by measuring a temperature dispersion under conditions of strain of 1%, and the frequency of 1Hz with raising the temperature from -50 to 100 °C by using a dynamic viscoelastic measurement apparatus (RPS-II from Reometrics Co.)

Examples of the preferred resins having the above glass transition temperature include a polyester resin, a polyurethane resin, an acrylic resin and a vinyl acetate resin. The polyester resin and the acrylic resin are particularly preferred, because they have an active hydrogen group and show transparency and flexibility.

Examples of the polyester resins include polyethylene terephthalate, polybuthylene terephthalate, polytrimethylene terephthalate and 2,6-polyethylene naphthalate.

Examples of the polyurethane resins include a polyurethane resin obtained by reacting an organic diisocyanate compound with a polymeric diol compound to synthesize a urethane prepolymer, and if necesarry reacting the prepolymer with a chain elongation agent and a reaction terminating agent.

Examples of the organic diisocyanate compounds include an aromatic diisocyanate compound such as tolylenediisocyanate, cycloaliphatic diisocyanate compound such as 1,4-cyclohexanediisocyanate and isophoronediisocyanate, aliphatic diisocyanate compound such as hexamethylenediisocyanate, and aromatic aliphatic diisocyanate compound such as α,α,α',α',-tetramethylxylylenediisocyanate. These compounds can be each used singly, or in combination of two more kinds. Of them, the cycloaliphatic diisocyanate compound, the aliphatic diisocyanate compound and the aromatic aliphatic diisocyanate compound are preferred.

Examples of the polymeric diol compounds include one or more polymeric diol compound, for example polyesterdiol compound such as polycaprolactonediols, polyesterdiols produced by condensation reaction of one or more diacid base such as adipic acid, sebacic acid and acid phthalic anhydride, with one or more glycols such as ethyleneglycol, propyleneglycol, 1,4-butanediol, neopentylglycol and 3-methyl-1,5-pentandiol; polyalkyleneglycol such as polyethyleneglycol and polypropyleneglycol; and polyetherdiolcompound such as alkyleneoxide adducts (for example ethyleneoxide of bisphenol A, propyleneoxide). The number average molecular weight of the polymeric diol compound preferably is in the range of 300 to 6,000. The polymeric diol compound is combined preferably with one or more low-molecular-weight diol compound, for example alkane diol such as 1,4-pentanediol, 2,5-hexanediol, 3-methyl-1,5-pentanediol; ethyleneglycol, propylenglycol, 1,4-butanediol and 1,3-butanediol. With regard to the ratio of the organic diisocyanate compound to the polymeric diol compound, the equivalent ratio of isocyanate group/hydroxyl group preferably is in the range of (1.3 - 3.0)/1.0, more preferably (1.5 - 2.0)/1.0.

As the chain elongation agent, low-molecular-weight diamine compound and diol compound can be used. As the reaction terminating agent, monoamine compound and monoalcohol compound can be used.

In the present invention, the polyurethane resin obtained by conventional method using the above materials can be used. The weight-average molecular weight of the polyurethane resin is preferably in the range of 5,000 to 200,000.

The hardness of the polyurethane is generally different depending on the molecular weight, the chemical structure and the equivalent ratio of the components. Therefore, it is possible to regulate the adhesion of the plating protective layer and the metal conductive layer, and the blocking resistance of the print production by combination of the components.

As the acrylic resin, homopolymer of, for example alkyl acrylate ester such as methyl acrylate, ethyl acrylate, butyl acrylate and hexyl acrylate; alkyl methacrylate ester such as methyl methacrylate, ethyl methacrylate, butyl methacrylate and hexyl methacrylate can be used. Polymethylmethacrylate, polyethylmethacrylate or polybutylmethacrylate are preferred.

The vinyl acetate resin is produced by polymerizing vinyl acetate. The polyvinyl acetate resin includes a resin produced by hydrolyzing less than 50% of vinyl acetate unit of the polyvinyl acetate resin. In addition, the vinyl acetate resin includes a homopolymer of vinyl acetate, or a copolymer produced by porymerization of the vinyl acetate and the other monomer (for example, olefin, such as ethylene) and having not less than 50 mole% of the vinyl acetate unit. One or more vinyl acetate resin can be used.

In the invention, the pretreatment agent for electroless plating preferably comprises a polyfunctional isocyanate compound having two or more isocyanate groups. In case the pretreatment agent for electroless plating comprises the synthetic resin and the polyfunctional isocyanate compound, the pretreatment layer is improved in adhesiveness and film-formability, whereby the plating protective layer and the metal conductive layer having the uniform thickness can be formed without damaging the pretreatment layer.

Examples of the polyfunctional isocyanate compounds include; polyisocyanate such as 2,6-tolylenediisocyanate, 2,4-tolylenediisocyanate, tolylenediisocyanate trimethylolpropane adducts, t-cyclehexane-1,4-diisocyanate, m-phenylenediisocyanate, p-phenylenediisocyanate, hexamethylenediisocyanate, 1,3,6-hexamethylenetriisocyanate, isophorondiisocyanate, 1,5-naphthalenediisocyanate, tolidinediisocyanate, xylylenediisocyanate, hydrogenerated xylylenediisocyanate, diphenylmethane-4,4'-diisocyanate, hydrogenerated diphenylmethane-4,4'-diisocyanate, lysinediisocyanate, lysine ester triisocyanate, triphenylmethanetriisocyanate, tris(isocyanateohenyl)thiophosphate, m-tetramethylxylylenediisocyanate, p-tetramethylxylylenediisocyanate, 1,6,11-undecanetriisocyanate, 1,8-diisocyanate-4-isocyanatemethyloctane, bicycloheptanetriisocyanate, 2,2,4-trimethylhexamethylenediisocyanate and 2,4,4-trimethylhexamethylenediisocyanate, and mixture thereof or polyalcohol adducts thereof.

Of them, from a viewpoint of a general versatility and a reactivity, 2,6-tolylenediisocyanate, 2,4-tolylenediisocyanate, tolylenediisocyanate-trimethylolpropane adducts and hexamethylenediisocyanate are preferred.

The pretreatment agent for electroless plating can be prepared by adding separately the synthetic resin, the polyfunctional isocyanate compound and the silanecoupling agent and mixing them, or by mixing preliminarily the synthetic resin with the polyfunctional isocyanate compound to prepare a resin composition, and then mixing the resin composition with the silanecoupling agent.

The pretreatment agent for electroless plating may comprise a proper solvent. Examples of the solvents include water, methyl alcohol, ethyl alcohol, 2-propanol, acetone, toluene, ethyleneglycol, polyethyleneglycol, dimethylhormamide, dimethylsulfoxide and dioxane. One or more solvents can be used. These solvents disperse or solve the synthetic resin and the polyfunctional isocyanate compound in the pretreatment agent for electroless plating, and can facilitate coating the pretreatment agent for electroless plating.

The pretreatment agent for electroless plating can comprise further an extender pigment, surfactant and colorant, if necessary.

In the present invention, if the transparent substrate coated with the pretreatment agent has a transparence and flexibility and can withstand the subsequent steps, there is not a limit of kinds of the transparent substrate. The transparent substrate includes glass, polyester (for example, polyethylene terephthalate (PET), polybutylene terephthalate), acrylic resin (for example, polymethylmethacrylate (PMMA)), polycarbonate (PC), polystyrene, cellulose triacetate, polyvinylalcohol, polyvinyl chloride, polyvinylidene chloride, polyethylene, ethylene-vinyl acetate copolymer, polyvinyl butyral, metal ion crosslinked ethylene-methacrylic acid copolymer, polyurethane and cellophane. Of them, PET, PC and PMMA are preferred, because these are less deteriorated by the processing treatments (heating, solvent and bending) and have an excellent transparency. The sheet, film and plate composed of the above materials can be used as the transparent substrate.

There is no limit of the thickness of the transparent substrate. However, the transparent substrate is preferably thin from a viewpoint of the light transmissive property of the light transmissive electrolytic shielding material. The thickness of the transparent substrate can be determined within the range of 0.05 to 5 mm depending on the configuration at the application and the needed mechanical strength.

The transparent substrate can be coated with the pretreatment agent by, for example, gravure-reverse, gravure coat, micro gravure coat, lip coat, roll reverse coat, wire bar coat, kiss coat, die coat, roll coat, spin coat, air-spray coat, airless spray coat, dipping and brushing.

In order to improve the cure degree of the coated layer, the coated pretreatment agent is dried preferably by heating at the range of 80 to 160 °C, preferably 120 to 140 °C. When the heating temperature is less than 80 °C, the adhesion of the pretreatment layer to the metal conductive layer may be reduced, because the formability of the pretreatment agent may not be enough owing to the slow evaporation rate of it. On the other hand, when the heating temperature is more than 160 °C, the adhesion of the pretreatment layer is apt to be reduced owing to the heat decomposition of it, in addition, the transparence of the pretreatment layer may be decreased owing to the discoloration. The drying time is in the range of 1 second to 5 minuites.

The thickness of the pretreatment layer preferably is in the range of 0.05 to 5 µm, in particular 0.1 to 2 µm. When the thickness is less than 0.05 µm, the thickness of the pretreatment layer is apt to be nonuniform. When the thickness is more than 5 µm, the occurrence of the blocking and the decrease of the catalyst activity are apt to be caused.

In the present invention, the surface of the transparent substrate on which the pretreatment layer will be formed is subjected preferably to an easy adhesion imparting treatment before the step for forming the pretreatment layer. This easy adhesion imparting treatment is a treatment which allows the transparent substrate to adhere firmly to the pretreatment layer obtained at the subsequent step. Therefore, the adhesion durability of the transparent substrate to the pretreatment layer can be improved significantly, so that the detachment of the plating protective layer and the metal conductive layer from the pretreatment layer can be prevented.

There is not a limit of kinds of the easy adhesion imparting treatment, if the easy adhesion imparting treatment can improve the adhesive of the transparent substrate to the pretreatment layer without decreasing the light transmissive property of the transparent substrate.

The easy adhesion imparting treatment comprises, for example, (i) forming a easy adhesion layer comprising a metal oxide on the transparent substrate, (ii) coating the transparent substrate with a solution comprising a synthetic resin and drying it to provide an easy adhesion layer, or (iii) subjecting the transparent substrate to a corona treatment or a plasma treatment. These methods can be carried out easily.

The method (i) is explained as the easy adhesion imparting treatment. The method (i) comprises a step for forming an easy adhesion layer comprising a metal oxide on the transparent substrate.

Any metal oxide can be used, provided that the metal oxide does not decrease the light transmissive property of the transparent substrate and improve adhesion of the substrate to the pretreatment layer. Oxide of metal such as Si, Ti, Sn, Al and Zn is used preferably as the metal oxide. In the easy adhesion layer, these metal oxides can be each used singly, or in combination of two more kinds. Examples of the metal oxides include preferably SiO₂, TiO₂, SnO₂, Al₂O₃ and ZnO.

A thin layer of these metal oxides can form the easy adhesion layer which has an excellent light transmissive property and an excellent adhesion to the transparent substrate and the pretreatment layer.

In addition, an easy adhesion layer comprising a nitride or oxyni-tiride of metal selected from the group consisting of Si, Ti, Sn, Al and Zn can be formed on the transparent substrate.

In the present invention, the easy adhesion layer comprising the metal oxide can be formed by using a conventionally-known art, preferably using vapor deposition method. Examples of the vapor deposition methods include a physical vapor deposition method, a vacuum deposition method, a sputtering method, an ion plating method, a chemical vapor deposition method and a plasma enhanced chemical vapor deposition method. Vacuum deposition method or sputtering method can be used preferably as the vapor deposition method. The easy adhesion layer is formed by the vapor deposition method using the metal of metal oxide and/or the metal oxide as a target, so that a low crystalline thin layer can be formed at low temperature.

In order to form the easy adhesion layer comprising the metal oxide on the transparent substrate by the vapor deposition method, a vapor deposition source, i.e. a film formation material is heated and melted by resistance heating, induction heating and electron beam irradiation, and then the obtained vapor is applied to the surface of the transparent substrate.

Examples of the film formation materials include a composite sintered compact of Si powder and SiO₂ powder, a SiO sintered compact produced from powder, guranula or agglomeration of SiO, a SiO₂ powder, a SiO₂ guranula, and a Si powder.

One or more electron guns can be used as the heating means of the vapor deposition method. In addition, other heating means can be used or can be combined. Examples of the other heating means include a resistance heating method, a high-frequency induction heating method, a laser beam heating method and an electron beam heating method.

It is possible to use oxygen, and if necessary nitrogen and steam, or to use ozone, ion assist as the reactant gas of the vapor deposition. These reactant gases can be improve the transparency of the easy adhesion layer. In this case, the gases preferably are introduced in such a way that the pressure of the atmosphere is in the range of 1 × 10⁻⁵ to 1 × 10⁻³ Torr. The deposition condition can be changed by adding bias to the transparent substrate or by increasing or decreasing the temperature of the transparent substrate.

The thickness of the easy adhesion layer comprising the metal oxide is preferably in the range of 10 to 500 nm, preferably 50 to 200 nm. In case the thickness of the easy adhesion layer is in the above range, it is possible to ensure sufficiently the adhesion.

In addition, a sputtering is used preferably to form the easy adhesion layer comprising the metal oxide. The sputtering can be carried out by using the metal of metal oxide and/or the metal oxide as a target and introducing the reactant gas such as oxygen. As the target and the reactant gas, the same materials previously described can be used.

There are no particular limitations on the sputtering condition. However, the target input power density preferably is not less than 1 W/cm², more preferably from 1.5 to 25 W/cm², most preferably from 2 to 20 W/cm². In addition, the sputtering is carried out preferably at a pressure of not less than 0.1 Pa, more preferably from 0.2 to 5 Pa, most preferably from 0.2 to 2 Pa.

The method (ii) of the easy adhesion imparting treatment is explained. The method (ii) comprises a step for coating the transparent substrate with a solution comprising a synthetic resin and drying it to form an easy adhesion layer. This method (ii) render a form of the easy adhesion layer comprising the synthetic resin easy, and enables significantly the transparent substrate to adhere firmly to the plating protective layer and the metal conductive layer.

The glass transition temperature of the synthetic resin is preferably in the range of -20 to 50 °C, in particular -10 to 20 °C. This prevents a blocking between the pretreatment layer and the plating protective layer or the metal conductive layer to improve the adhesion of those.

Examples of the synthetic resins having the above glass transition temperature preferably include a polyester resin, a polyurethane resin, an acrylic resin and a vinyl acetate resin. The polyester resin is preferred particularly, because of its high light transmissive property and high flexibility property.

Examples of the polyester resins include polyethylene terephthalate, polybuthylene terephthalate, polytrimethylene terephthalate and 2,6-polyethylene naphthalate.

Examples of the polyurethane resin include polyurethane resins obtained by reacting an organic diisocyanate compound with a polymeric diol compound to synthesize a urethane prepolymer, and if necesarry reacting the urethane prepolymer with a chain elongation agent and a reaction terminating agent.

Examples of the organic diisocyanate compounds include aromatic diisocyanate compounds such as tolylenediisocyanate, cycloaliphatic diisocyanate compounds such as 1,4-cyclohexanediisocyanate and isophoronediisocyanate, aliphatic diisocyanate compounds such as hexamethylenediisocyanate, and aromatic aliphatic diisocyanate compounds such as α,α,α',α',-tetramethylxylylenediisocyanate. One or more compounds can be used. Of these, the cycloaliphatic diisocyanate compound, the aliphatic diisocyanate compound and the aromatic aliphatic diisocyanate compounds are preferred.

Examples of the polymeric diol compounds include one or more polymeric diol compound, for example polyesterdiol compounds such as polycaprolactonediols and polyesterdiols produced by condensation reaction of one or more diacid base such as adipic acid, sebacic acid and acid phthalic anhydride, with one or more glycols such as ethyleneglycol, propyleneglycol, 1,4-butanediol, neopentylglycol and 3-methyl-1,5-pentandiol; polyalkyleneglycol such as polyethyleneglycol and polypropyleneglycol; and polyetherdiol compound such as alkyleneoxide adducts (for example ethyleneoxide of bisphenol A, propyleneoxide). The number average molecular weight of the polymeric diol compound is preferably in the range of 300 to 6,000. The polymeric diol compound is combined preferably with one or more low-molecular-weight diol compound, for example alkane diol such as 1,4-pentanediol, 2,5-hexanediol and 3-methyl-1,5-pentanediol; ethyleneglycol, propylenglycol, 1,4-butanediol and 1,3-butanediol. As the ratio of the organic diisocyanate compound to the polymeric diol compound, the equivalent ratio of isocyanate group/hydroxyl group is generally (1.3 - 3.0)/1.0, more preferably (1.5 - 2.0)/1.0

As chain elongation agent, a low-molecular-weight diamine compound and diol compound can be used. As the reaction terminating agent, a monoamine compound and a monoalcohol compound can be used.

In the present invention, the polyurethane resin obtained by known methods using the above materials can be used. The weight-average molecular weight of the polyurethane resin is preferably in the range of 5,000 to 200,000.

The hardness of the polyurethane resin is generally different depending on the molecular weight, the chemical structure and the equivalent ratio of the components. Therefore, it is possible to regulate the adhesion to the plating protective layer and the metal conductive layer and the brocking resistance of the print production by combining these components.

Examples of the acrylic resins include a homopolymer, for example, alkyl acrylate ester such as methyl acrylate, ethyl acrylate, butyl acrylate and hexyl acrylate, alkyl methacrylate ester such as methyl methacrylate, ethyl methacrylate, butyl methacrylate and hexyl methacrylate. The polymethylmethacrylate, polyethylmethacrylate and polybutylmethacrylate are preferred.

The vinyl acetate resin is produced by polymerizing vinyl acetate. On the other hand, the polyvinyl acetate resin includes a resin produced by hydrolyzing less than 50% of vinyl acetate unit of the polyvinyl acetate resin. In addition, the vinyl acetate resin includes a homopolymer of vinyl acetate, or a copolymer produced by porymerization of the vinyl acetate and the other monomer (for example, olefin, such as ethylene) and having not less than 50 mole% of the vinyl acetate unit. One or more vinyl acetate resin can be used.

The solution comprising the synthetic resin comprises a polyfunctional isocyanate compound having two or more isocyanate groups. When the solution comprises the synthetic resin and the polyfunctional isocyanate compound, the adhesion and formability of the pretreatment layer can be improved.

Examples of the polyfunctional isocyanate compounds having two or more isocyanate groups include;
polyisocyanate, such as 2,6-tolylenediisocyanate, 2,4-tolylenediisocyanate, tolylenediisocyanate trimethylolpropane adducts, t-cyclehexane-1,4-diisocyanate, m-phenylenediisocyanate, p-phenylenediisocyanate, hexamethylenediisocyanate, 1,3,6-hexamethylenetriisocyanate, isophorondiisocyanate, 1,5-naphthalenediisocyanate, tolidinediisocyanate, xylylenediisocyanate, hydrogenerated xylylenediisocyanate, diphenylmethane-4,4'-diisocyanate, hydrogenerated diphenylmethane-4,4'-diisocyanate, lysinediisocyanate, lysine ester triisocyanate, triphenylmethanetriisocyanate, tris(isocyanateohenyl)thiophosphate, m-tetramethylxylylenediisocyanate, p-tetramethylxylylenediisocyanate, 1,6,11-undecanetriisocyanate, 1,8-diisocyanate4-isocyanatemethyloctane, bicycloheptanetriisocyanate, 2,2,4-trimethylhexamethylenediisocyanate, and 2,4,4-trimethylhexamethylenediisocyanate and mixture or polyalcohol adducts thereof.

Of them, 2,6-tolylenediisocyanate, 2,4-tolylenediisocyanate, tolylenediisocyanate trimethylolpropane adducts and hexamethylenediisocyanate are preferable, from a viewpoint of a general versatility and a reactivity.

Examples of the solvents of the solution comprising the synthetic resin include a solvent which can dissolve or disperse the synthetic resin such as water, methyl alcohol, ethyl alcohol, 2-propanol, acetone, toluene, ethyleneglycol, polyethyleneglycol, dimethylhormamide, dimethylsulfoxide and dioxane, methyl ethyl ketone, methyl isobutyl ketone, cellosolve acetate and acetic ether.

The transparent substrate can be coated with the solution comprising the synthetic resin by, for example, gravure-reverse, gravure coat, micro gravure coat, lip coat, roll reverse coat, wire bar coat, kiss coat, die coat, roll coat, spin coat, air-spray coat, airless spray coat, dipping and brushing.

In order to increase the cure degree of the coated layer, it is preferred that the solution comprising the synthetic resin is dried by heating at the temperature of 70 to 120 °C, preferably of 90 to 110 °C. When the coated layer is dried by heating, the drying time is preferably in the range of 5 seconds to 5 minutes.

The thickness of the easy adhesion layer comprising the synthetic resin is preferably in the range of 0.05 to 5 µm, in particular 0.1 to 2 µm. If the thickness of the easy adhesion layer is in the range, it is possible to ensure sufficiently the adhesion.

The method (iii) of the easy adhesion imparting treatment is explained. The method (iii) includes a step for applying a corona treatment or a plasma treatment to the transparent substrate. This method can cause the surface of the transparent substrate to form fine unevenness, so that the adhesion of the transparent substrate to the plating protective layer and the metal conductive layer can be significantly improved.

In the corona treatment, when a region of a strong electric field is localized as in the case that a high-voltage is applied to an electric wire, the localized electric discharge (corona electric discharge) may be generated in the region. The surface of the transparent substrate is activated by placing it under the electric discharge.

The transparent substrate can be subjected to the corona treatment by using a corona treater which is generally available to a skilled person. The corona electric discharge is generated usually by using alternating-current. The positive or negative corona can be used, if necessary. The corona treatment can be carried out by using a corona electric discharge treater which has a high-frequency oscillator and electrodes and can treat continuously, and passing the transparent substrate between the corona electric discharge electrode and the electrode couple.

On the other hand, in the plasma treatment, a high voltage is applied to a low-pressure gas atmosphere, and then the transparent substrate is exposed to the glow discharge to treat the surface of the transparent substrate with active particles generated by the glow discharge, such as electron, ion, exited atom, radical and ultraviolet.

The plasma treatment can be carried out by using a plasma treater which is generally available to a skilled person. The plasma discharge can be carried out under reduced pressure or atmosphere pressure. From the viewpoint of cost of the plasma treater, it is preferable to discharge under the atmosphere pressure.

Examples of the gases which can be used to generate the plasma gas include inactive gas, such as helium, argon, krypton, xenon, neon, radon and nitrogen, oxygen, air, carbon monoxide, carbon dioxide, carbon tetrachloride, chloroform, hydrogen, ammonia, carbon tetrafluoride, trichloro-fluoroethane and trichlorofluoromethane. In addition, a fluorogas and a mixed gas of the above gasses can be used. Examples of the preferred combinations of the gasses include argon/oxygen, argon/ammonia, argon/helium/oxygen, argon/carbon dioxide, argon/nitrogen/nitrogen, argon/helium/nitrogen, argon/helium/nitrogen/carbon dioxide, argon/helium, argon/helium/acetone, helium/acetone, helium/air and argon/helium/sirane.

The gas pressure of the system at the plasma treatment is preferably in the range of 0.001 to 0.1 Torr, preferably 0.01 to 0.5 Torr. The treatment time of it is preferably from 1 to 5 minutes.

In the present invention, the dot-shaped plating protective layer is formed on the pretreatment layer. The plating protective layer is formed to keep the specific part (i.e., dot pattern) of the pretreatment layer free from influence of the electroless plating and form the metal conductive layer on the part of the pretreatment layer which is not form the plating protective layer, so that a metal conductive layer having the mesh pattern can be obtained.

The provision of the dot-shaped plating protective layer on the pretreatment layer is preferably carried out by printing, whereby the dot-shaped plating protection having desired pattern can be formed by a simple method.

It is preferred that the plating protective layer is formed on the pretreatment layer by printing resist ink comprising a resin having a tolerance to a nonelectorolytic plating solution and dissolved in a solvent.

Examples of the resins having resistance to the nonelectorolytic plating solution include at least one selected from the group consisting of an acrylic resin, a polyester resin, a vinyl chloride resin and a styrene resin. These resins can be each used singly, or in combination of two more kinds. These resin, in particular the acrylic resin can form the plating protective layer having the high adhesion to the pretreatment layer and the mesh-shaped metal conductive layer obtained in the after steps and a high light transmissive property. Therefore, the plating protective layer can be used directly for the light transmissive electrolytic shielding material without removing it, so that the efficiency of the manufacturing process can be improved.

Of the resins having tolerance to the nonelectorolytic plating solution, the acrylic resin is preferred. Examples of the acrylic resins include preferably a homopolymer of acrylic acid alkyl ester such as methyl acrylate, ethyl acrylate, butyl acrylate and hexyl acrylate, methacrylic acid ester such as methyl methacrylate, ethyl methacrylate, butyl methacrylate and hexyl methacrylate. Polymethyl methacrylate, polyethyl methacrylate and polybutyl methacrylate are more preferred.

The resist ink comprises preferably the resin in the amount of 5 to 50 % by weight, more preferably 10 to 40 % by weight. If the amount of the resin is less than 5 % by weight, the plating protective layer having a specific thickness may not be obtained. If the amount of the resin is more than 50 % by weight, the light transmissive property of the plating protective layer may be reduced.

The solvent used for the resist ink should dissolve the resin and form easily a film. Examples of the solvents include dichloromethane, tetrahydrofuran, cyclohexanone, methyl cellosolve acetate, ethyl cellosolve acetate, propyleneglycol monomethylether acetate, propyleneglycol mono-ethylether acetate, methyl lactate, ethyl lactate, 2-ethoxyethyl acetate, methyl pyruvate, ethyl pyruvate, methyl 3-methoxypropionate, ethyl 3-methoxypropionate, N,N-dimethylformamide, N,N-dimethylacetamide, N-methyl-2-pyrolidone, cyclohexanone, methyl ethyl ketone, 2-heptanone, 1,4-dioxane, diethyleneglycol monomethyl ether, diethyleneglycol dimethyl ether, ethylene glycol monoisopropyl ether, toluene, acetic ether and butyl acetate.

The resist ink may a contain clear filler and a polymer thickener so that the printing precision can be improved.

The viscosity of the resist ink is preferably in the range of 1000 to 5000 cps, more preferably 2500 to 4000 cps at 25 °C. This can improve the accuracy of dimension of the plating protective layer.

The resist ink can be printed on the pretreatment layer by printing method such as a gravure printing, a screen printing, an offset lithography, an electrostatic printing and a flexo printing. From the viewpoint of forming a thin line, the gravure printing is preferred. If the gravure printing is used, the printing speed is preferably in the range of 5 to 50 m/minute.

On the other hand, the plating protective layer can be formed by transferring printing. If the transferring printing is used, the resist ink can be transferred by printing the resist ink on a substrate sheet for the transferring printing which is different from the pretreatment layer by using the above printing method, and then combining the substrate sheet with the pretreatment layer by laminate heating, drying laminate, wet laminate or extrusion laminate, and then separating only the substrate sheet.

A lot of the plating protective layers are formed on the pretreatment layer. The parts of the pretreatment layer exposing in the concave portion located between the plating protective layers are in the shape of a mesh such as a periodic lattice and a reticulation. Examples of the shapes of the plating protective layer include a circle, an ellipse, a polygon and a line, preferably the polygon, more preferably the square. As a result from these shapes, the metal conductive layer having a high light transmissive property and a high electromagnetic wave shielding property can be formed.

The plating protective layer forms the opening part of the metal conductive layer at the after step. If the opening ratio of the metal conductive layer is high and the dimension of the opening part is minute, the metal conductive layer can ensure the high light transmissive property. Therefore, the dimension of the plating protective layer is preferably minute and can be determined depending on the dimension of the opening part of the metal conductive layer. If the shape of the plating protective layer is the polygon, in particular the square, the length of a side of it is preferably in the range 100 to 400 µm, more preferably 200 to 300 µm.

From a viewpoint of providing the high light transmissive property and the high electromagnetic wave shielding property to the metal conductive layer, the dot-shaped plating protective layer is arranged preferably at regular intervals. The thickness of the plating protective layer is preferably in the range of 0.1 to 5 µm.

In addition, the plating protective layer can be formed on the central part of the pretreatment layer excepting the surrounding part of it, so that the mesh-shaped metal conductive layer can be formed on the central part of the pretreatment layer and the metal conductive layer having a shape of a flame can be formed on the surrounding part of the pretreatment layer.

A lot of the dot-shaped plating protective layer can be obtained by drying the printed resist ink. The drying can be carried out preferably by heating the printed resist ink at a temperature of 70 to 120 °C, more preferably 90 to 110 °C. If the temperature of the drying is less than 70 °C, the evaporation rate of the solvent may be low and the film-forming ability may be decreased. If the temperature of the drying is more than 120 °C, the resin may be decomposed. The drying time after the printing preferably is in the range of 5 seconds to 5 minutes.

The total light transmittance of the plating protective layer preferably is not less than 85 %, in particularly not less than 90 %. As a result of this, the electromagnetic wave shielding material having a high light transmissive property can be obtained.

In the present invention, a metal conductive layer is then formed on the exposing part of the pretreatment layer without forming the plating protective layer by electroless plating so as to have the mesh pattern. By the electroless plating, the fine metallic particles are deposited between the plating protective layer and on the surrounding part of it arranged on the pretreatment layer to form a coated layer, so that the metal conductive layer can be obtained.

The electroless plating can be carried out by a known method using a electroless plating bath, for example, by immersing plating materials in the electroless plating bath comprising a plating metallic salt, a chelating agent, a pH adjuster and a reducing agent as basic constituents, or by separating a plating solution into not less than 2 parts and adding them.

If the plating metal has conductive property and platable property, there are no particular limitations on the plating metal. The plating metal may be an elemental metal, an alloy, a conductive metal oxide, a metallic thin film, or fine particles coated uniformly.

Examples of the metals of the metal conductive layer which can be formed by the electroless plating include aluminum, nickel, indium, chrome, gold, vanadium, tin, cadmium, silver, platinum, copper, titanium, cobalt and lead. In particular, silver, copper and aluminum are preferred, because the metal conductive layer having high electromagnetic wave shielding property can be obtained. The metal conductive layer formed by using the above metal has a high adhesive property to the pretreatment layer and the plating protective layer, a high light permeation property and a high electromagnetic wave shielding property. Therefore, the nonelectorolytic plating is generally carried out by using the above metals. For example, an electroless Cu plating bath and a electroless nickel plating bath can be used as the electroless plating bath.

The electroless plating has been known and can be carried out by known methods at room temperature or at heated temperature with appropriately selecting arbitrarily chemicals. In case the metal conductive layer comprising copper are formed, the transparent substrate on which the pretreatment layer and the plating protective layer are formed is immersed in a solution comprising an aqueous copper salt such as copper sulfate in an amount of 1 to 100 g/L, in particularly 5 to 50 g/L, a reduction agent such as formaldehyde in an amount of 0.5 to 10 g/L, in particularly 1 to 5 g/L and a complexing agent such as EDTA in an amount of 20 to 100 g/L, in particularly 30 to 70 g/L, and having a pH in the range of 12 to 13.5, in particularly 12.5 to 13 at temperature of 50 to 90 °C for 30 seconds to 60 minutes.

In the electroless plating, the substrate can be vibrated and rotated. In addition, the area around the substrate can be stirred by air.

A line width of the metal conductive layer preferably is not more than 50 µm, more preferably not more than 40 µm, in particularly in the range of 10 to 30 µm. The metal conductive layer preferably has the mesh-pattern having aperture ratio of not less than 75 %. The "aperture ratio" means a total area of the opening parts of the metal conductive layer based on the effective area of the metal conductive layer.

The mesh-pattern of the metal conductive layer preferably is a geometric pattern. The figure of the opening part of the mesh pattern is selected arbitrarily from a parallelogram such as a square and a rectangle, a circle and a regular hexagonal (honeycomb geometry). If the opening parts are arranged regularly, every parts of the metal conductive layer have a uniform property (mainly a light transmissive property and an electromagnetic wave shielding property).

The mesh-shaped metal conductive layer may be formed on the central part of the pretreatment layer and the metal conductive layer having a shape of a flame may be formed on the surrounding part of the pretreatment layer. This structure is preferred, because the mesh-pattern part of the metal conductive layer can be protected.

In the present invention, it is possible to electrolytically plate the metal conductive layer, if necessary.

In the present invention, as shown by the Fig 1, the metal conductive layer 14 can be subjected to a blackening treatment to form a blackening treatment layer 15 on at least part of the surface of the metal conductive layer 14 (an arrow A4 of Fig. 1).

The blackening treatment is carried out preferably by subjecting the metal conductive layer to an oxidation treatment or a sulfurization treatment. In particular, the sulfurization treatment preferably is used for improving the anti-glare property and ensuring the simple waste liquid treatment and the environment safe.

In case the oxidation treatment is carried out as the blackening treatment, the blackening treatment liquid used in the oxidation treatment includes a mixed aqueous solution of a hypochlorite and a sodium hydrate, a mixed aqueous solution of a chlorite and a sodium hydrate and a mixed aqueous solution of a peroxodisulfuric acid and a sodium hydrate. In particularly, from a viewpoint of economic efficiency, the mixed aqueous solution of the hypochlorite and the sodium hydrate and the mixed aqueous solution of the chlorite and the sodium hydrate are preferred.

In case the sulfurization treatment is carried out as the blackening treatment, the blackening treatment liquid includes an aqueous solution comprising, for example, a potassium sulfide, a barium sulfide and a ammonium sulfide, preferably the potassium sulfide and the ammonium sulfide. The ammonium sulfide is preferred particularly, because it can be used at low temperature.

The present invention enables formation of easily the metal conductive layer having sufficient thickness by the electroless plating and formation of the plating protective layer having enhanced total light transmittance property. Therefore, the present invention can provide the light transmissive electoromagnetic shielding material reduced the cost of the production. In addition, it is possible to provide the light transmissive electoromagnetic shielding material whose transparent substrate and pretreatment layer have a high light transmissive property, because there is no need to rough the substrate.

The light transmissive electoromagnetic shielding material comprises the transparent substrate, the pretreatment layer arranged on the transparent substrate, the dot-shaped plating protective layer arranged on the pretreatment layer, and the mesh-shaped metal conductive layer arranged on the exposing part of the pretreatment layer having no plating protective layer, and the pretreatment layer is a coated layer of a pretreatment agent comprising a noble metal compound and a mixture of silane coupling agent and azole compound or a reaction product thereof. The light transmissive electoromagnetic shielding material having the above constitution can be manufactured easily and at low cost by the above mentioned process of the present invention.

In addition, the pretreatment layer containing the synthetic resin ensures the high adhesion of the pretreatment layer to the metal conductive layer and the plating protective layer, whereby the peeling of the metal conductive layer can be prevented.

In addition, if the transparent substrate is subjected to the easy adhesion imparting treatment, a high adhesion of the transparent substrate to the plating protective layer and the metal conductive layer can be ensured.

Example of the transparent substrate subjected to the easy adhesion imparting treatment includes a transparent substrate having an easy adhesion layer mainly consisting of at least one oxide of metal selected from the group consisting of Si, Ti, Sn, Al and Zn thereon. The easy adhesion layer of the above metal oxide has a high light transmissive property and extremely improves an adhesion of the transparent substrate to the plating protective layer and the metal conductive layer.

The transparent substrate having an adhesive treatment layer comprising a synthetic resin thereon is preferably used.

The synthetic resin preferably includes a resin having a glass transition temperature in the range of -20 to 50 °C. The resin prevents a blocking between the easy adhesion layer and the plating protective layer or the metal conductive layer to improve the adhesion of those. Examples of the synthetic resins preferably include polyester resin, polyurethane resin, acrylic resin and vinyl acetate resin. These resins are preferred owing to its high light transmissive property and flexibility.

The easy adhesion layer comprising the synthetic resin preferably comprises a polyfunctional isocyanate compound having two or more isocyanate groups. Adhesion and film-forming ability of the easy adhesion layer can be improved by the synthetic resin and the polyfunctional isocyanate compound.

In addition, example of the transparent substrate subjected to the easy adhesion imparting treatment preferably includes a transparent substrate subjected a corona treatment or a plasma treatment.

The provision of light transmissive electoromagnetic shielding material ensures the high light transmissive property of the pretreatment layer and the transparent substrate by using the electroless plating pretreatment agent comprising the specific component. Therefore, the total light transmittance of the plating protective layer preferably is not less than 75 %, in particularly is in the range of 80 to 90 %.

A total light transmittance of the light transmissive electoromagnetic shielding material can be determined by measuring the total light transmittance in the direction of the thickness of the light transmissive electoromagnetic shielding material by means of a full automatic Digital Haze Computer HGM-2DP manufactured by Suga Test Instrument Co., Ltd.

The blackening treatment layer can be formed on at least a part of the surface of the metal conductive layer to provide anti-glare property to the metal conductive layer.

The explanations of each layers of the light transmissive electoromagnetic shielding material are described as above, and therefore, omitted.

The light transmissive electoromagnetic shielding material of the present invention preferably can be used in a applications required the light transmissive property, for example, display of display devices, which may generate the electromagnetic wave, such as LCD, PDP and CRT, a surface of transparent glass and transparent panel of facility and building. It is preferable to use the light transmissive electoromagnetic shielding material as a display filter for the display device, because it has a high light transmissive property and a high electromagnetic wave shielding property.

The display filter can be obtained, for example by laminating the light transmissive electoromagnetic wave shielding material on a transparent substrate such as glass substrate.

### EXAMPLE

The present invention is illustrated in detail below using the following Examples.

### [Example 1]

γ-Glycidoxypropyltrialkoxysilane was added to imidazole at a mole ratio of 1 : 1, and reacted for an hour and for 100 minutes, to prepare a reaction product. Palladium chloride was added to an aqueous solution consisting of the reaction product in the amount of 5 wt% with stirring at 25 °C to prepare a solution having palladium chloride concentration of 10 g/L. This solution was diluted with n-butanol by 100-fold by volume to prepare a pretreatment agent having palladium chloride concentration of 100 mg/L. The pretreatment agent was coated on the glass plate (the thickness of 5 mm) in the coating amount of 2 g/m², and dried at 160 °C for 5 minuites to form a pretreatment layer on the glass plate.

Then, a resist ink comprising dichloromethane, tetrahydrofuran and cyclohexanone in a mass ratio of 20:60:20 as a solvent and 30 wt% of a polymethylmethacrylic resin was printed in the dot pattern on the pretreatment layer by gravure offset printing to form a plating protective layer composed of a lot of minimum convex parts on the pretreatment layer. The shape of the dot was a square having a side of 234 µm, the distance between the dots was 20 µm, and the dots arrangement was a square grid. The printing thickness after drying was 3 µm.

The glass plate on which the plating protective layer and the pretreatment layer had been formed was immersed in a electroless plating solution (Melpate Cud-5100 manufactured by Meltex Co., Ltd) and subjected to electroless plating treatment to form a grid metal conductive layer. The metal conductive layer had a thickness of 1.5 µm, a line width of 23 µm and an aperture ratio of 83 %.

In addition, the glass plate on which the metal conductive layer had been formed was subjected to a blackening treatment as follows.

The composition of the blackening treatment solution (aqueous solution)
sodium chlorite: 10 wt%
sodium hydrate: 4 wt%

The condition of the blackening treatment
bath temperature: about 60 °C
time: 5 minutes

A light transmissive electoromagnetic shielding material having the metal conductive layer whose surface was subjected to the blackening treatment can be obtained. The thickness of the blackening treatment layer formed on the surface of the light transmissive electoromagnetic shielding material was 1.5 µm on average.

### [Example 2]

γ-Glycidoxypropyltrialkoxysilane was added to imidazole at a mole ratio of 1 : 1, and reacted for an hour and for 100 minutes, to prepare a reaction product. Palladium chloride was added to an aqueous solution consisting of the reaction product in an amount of 5 wt% with stirring at 25 °C to prepare a solution having palladium chloride concentration of 10 g/L. This solution was added to a two-pack curable type polyurethane resin composition to prepare a pretreatment agent having the palladium chloride concentration of 100 mg/L.

The two-pack curable type polyurethane resin composition comprises a polyester resin (AD-335A manufactured by Toyo-Morton Co., Ltd, Tg: 10°C) and a cycloaliphatic isocyanate (CAT-10L manufactured by Toyo-Morton Co., Ltd) at a mole ratio of 100:0.5 and a solid concentration of 10 % by weight.

The pretreatment agent was coated on the PET film (the thickness of 250 µm) and dried at 160 °C for 5 minuites to form a pretreatment layer on the PET film. The thickness of the pretreatment layer was 0.1 µm. The total light transmittance of the PET film and the pretreatment layer in the direction of the thickness of those was 88%.

Then, a resist ink comprising dichloromethane, tetrahydrofuran and cyclohexanone in a mass ratio of 20:60:20 as a solvent and 30 wt% of polymethylmethacrylic resin was printed in the dot pattern on the pretreatment layer by gravure offset printing to form a plating protective layer composed of a lot of minimum convex parts on the pretreatment layer. The shape of the dot was a square having a side of 234 µm, the distance between the dots was 20 µm, and the dots arrangement was a square grid. The printing thickness after drying was 3 µm. The total light transmittance of the PET film, the pretreatment layer and the plating protective layer in the direction of those was 80%.

The PET film on which the plating protective layer and the pretreatment layer had been formed is immersed in an electroless plating solution (Melpate CU-5100 manufactured by Meltex Co., Ltd) and subjected to electroless plating treatment to form a grid metal conductive layer. The metal conductive layer had a thickness of 1.5 µm, a line width of 23 µm and an aperture ratio of 83 %.

In addition, the PET film on which the metal conductive layer had been formed was subjected to a blackening treatment as follows.

The composition of the blackening treatment solution (aqueous solution)
sodium chlorite: 10 wt%
sodium hydrate: 4 wt%

The condition of the blackening treatment
bath temperature: about 60 °C
time: 5 minutes

A light transmissive electoromagnetic shielding material having the metal conductive layer whose surface was applied the blackening treatment can be obtained. The thickness of the blackening treatment layer formed on the surface of the light transmissive electoromagnetic shielding material was 1.5 µm on average.

### [Example 3]

SiO₂ film (the thickness of 50 µm) was formed on the PET film (the thickness of 250 µm) by using DC magnetron sputtering system. At this time, Si target was used as the target. The degree of vacuum was 0.5 Pa at the formation. O₂ was used as an introduced gas. The temperature of a plate was 25 °C.

γ-Glycidoxypropyltrialkoxysilane was added to imidazole at the mole ratio of 1 : 1, and reacted for an hour and for 100 minutes, to prepare a reaction product. Palladium chloride was added to an aqueous solution consisting of the reaction product in an amount of 5 wt% with stirring at 25 °C to prepare a solution having palladium chloride concentration of 10 g/L. This solution was diluted with n-butanol by 100-fold by volume to prepare a pretreatment agent having palladium chloride concentration of 100 mg/L. The pretreatment agent was coated on the SiO₂ film formed on the PET film in a coating amount of 2 g/m², and dried at 160 °C for 5 minuites to form a pretreatment layer on the SiO₂ film. The total light transmittance of the PET film, the SiO₂ film and the pretreatment layer in the direction of the shickness of those was 85%.

Then, a resist ink comprising dichloromethane, tetrahydrofuran and cyclohexanone in a mass ratio of 20:60:20 as a solvent and 30 wt% of polymethylmethacrylic resin was printed in the dot pattern on the pretreatment layer by gravure offset printing to form a plating protective layer composed of a lot of minimum convex parts on the pretreatment layer. The shape of the dot was a square having a side of 234 µm, the distance between the dots was 20 µm, and the dots arrangement was a square grid. The printing thickness after drying was 3 µm. The total light transmittance of the PET film, the SiO₂ film, the pretreatment layer and the plating protective layer in the direction of those was 75%.

The glass plate on which the plating protective layer and the pretreatment layer had been formed was immersed in an electroless plating solution (Melpate CU-5100 manufactured by Meltex Co., Ltd) and subjected to electroless plating treatment to form a grid metal conductive layer. The metal conductive layer had a thickness of 1.5 µm, a line width of 23 µm and an aperture ratio of 83 %.

In addition, the PET film on which the metal conductive layer had been formed was subjected to a blackening treatment as follows.

The composition of the blackening treatment solution (aqueous solution)
sodium chlorite: 10 wt%
sodium hydrate: 4 wt%

The condition of the blackening treatment
bath temperature: about 60 °C
time: 5 minutes

A light transmissive electoromagnetic shielding material (1) having the metal conductive layer whose surface was subject to the blackening treatment can be obtained. The thickness of the blackening treatment layer formed on the surface of the light transmissive electoromagnetic shielding material (1) was 1.5 µm on average.

### [Example 4]

A two-pack curable type polyurethane resin composition comprising a polyester resin (AD-335A manufactured by Toyo-Morton Co., Ltd, Tg: 10°C) and a cycloaliphatic isocyanate (CAT-10L manufactured by Toyo-Morton Co., Ltd) at a mole ratio of 100:0.5 and having the solid concentration of 10 % by weight was coated on the PET film (the thickness of 250 µm) by roll coating method and dried at 160 °C for 5 minuites to form a easy adhesion layer (the thickness of 0.5 µm).

A light transmissive electoromagnetic shielding material (2) was produced by the same manner as the example 3 other than the PET film having the above easy adhesion layer was used in place of the PET film having SiO₂ film.

### [Example 5]

Only one side of a PET film (the thickness of 250 µm) was subjected to corona treatment under air atmosphere. At the corona treatment, the distance between the film and the electrode was 1 mm, the processing speed was 60 m/min, and the power consumption was in the range of 20 to 160 W/m²/min.

A light transmissive electoromagnetic shielding material (3) was produced in the same manner as the example 3 other than that the PET film subjected to the corona treatment was used in place of the PET film having SiO₂ film.

As described above, the present invention can provide the light transmissive electoromagnetic shielding material having high light transmissive property and high electoromagnetic shielding property by a simpler method compared with the conventional method.

### Industrial Applicability

The present invention can produce the mesh-shaped metal conductive layer having the enough thickness by the electroless plating without the vapor deposition. As a result, the present invention can provide a process for preparation of the light transmissive electoromagnetic shielding material which can be reduced the steps and can be improved the manufacturing efficiency. Therefore, the present invention can provide the light transmissive electoromagnetic shielding material reduced the manufacturing cost, and the display filter prepared by using the same.

## Claims

1. A process for preparing a light transmissive electoromagnetic shielding material comprising;
coating a transparent substrate with a pretreatment agent for electroless plating comprising a noble metal compound and a mixture of silane coupling agent and azole compound or a reaction product thereof to form a coated layer and drying the coated layer to provide a pretreatment layer on the transparent substrate,
forming a plating protective layer in the dot pattern on the pretreatment layer, and
subjecting the exposing part of the pretreatment layer having no plating protective layer to electroless plating to form a metal conductive layer in the mesh pattern.

2. A process as defined in claim 1, wherein the silane coupling agent is an epoxy-containing silane compound.

3. A process as defined in claim 1 or 2, wherein the silane coupling agent is γ-glycidoxypropyltrialkoxysilane.

4. A process as defined in any of claims 1 to 3, wherein the azole compound is imidazole.

5. A process as defined in any of claims 1 to 4, wherein the noble metal compound is a compound containing at least one metal atom selected from the group consisting of palladium, silver, platinum and gold.

6. A process as defined in any of claims 1 to 5, wherein the pretreatment agent for electroless plating further comprises a synthetic resin.

7. A process as defined in claim 6, wherein the synthetic resin has glass transition temperature of from -20 to 50 °C.

8. A process as defined in claim 6 or 7, wherein the synthetic resin is at least one selected from the group consisting of polyester resin, polyurethane resin, acrylic resin and polyvinyl acetate resin.

9. A process as defined in any of claims 1 to 8, wherein the pretreatment agent for electroless plating further comprising a polyfunctional isocyanate compound having two or more isocyanate groups.

10. A process as defined in any of claims 1 to 9, which further comprising;
subjecting a side of the transparent substrate to be formed the pretreatment layer to an easy adhesion imparting treatment before the step for forming the pretreatment layer.

11. A process as defined in claim 10, wherein the easy adhesion imparting treatment is carried out by forming an easy adhesion layer comprising at least one oxide of metal selected from the group consisting of Si, Ti, Sn, Al and Zn on the transparent substrate.

12. A process as defined in claim 11, wherein the easy adhesion layer is produced by a vapor deposition method.

13. A process as defined in claim 12, wherein the vapor deposition method is a physical vapor deposition method, a vacuum deposition method, a sputtering method, an ion plating method, a chemical vapor deposition or a plasma enhanced chemical vapor deposition

14. A process as defined in claim 12 or 13, wherein the vapor deposition method is a vacuum deposition method or a sputtering method.

15. A process as defined in claim 10, wherein the easy adhesion imparting treatment is carried out by coating the transparent substrate with a solution comprising a synthetic resin and drying it to form an easy adhesion layer.

16. A process as defined in claim 15, wherein the synthetic resin has glass transition temperature of in the range of -20 to 50 °C.

17. A process as defined in claim 15 or 16, wherein the synthetic resin is selected from the group consisting of polyester resin, polyurethane resin, acrylic resin and vinyl acetate resin.

18. A process as defined in any of claims 15 to 17, wherein a solution comprising the synthetic resin further comprises a polyfunctional isocyanate compound having two or more isocyanate groups.

19. A process as defined in any of claims 15 to 18, wherein the easy adhesion layer has the thickness in the range of 0.05 to 5 µm.

20. A process as defined in claim 10, wherein the easy adhesion imparting treatment is carried out by subjecting the transparent substrate to a corona treatment or a plasma treatment.

21. A process as defined in any of claims 1 to 20, wherein the drying is carried out at a temperature of 80 to 160 °C at the step for forming the pretreatment layer on the transparent substrate.

22. A process as defined in any of claims 1 to 21, wherein the plating protective layer comprises at least one selected from the group consisting of acrylic resin, polyester resin, polyvinyl chloride resin and polystyrene resin.

23. A process as defined in any of claims 1 to 22, wherein the metal conductive layer comprises silver, copper and aluminum.

24. A process as defined in any of claims 1 to 20, which further comprising;
subjecting the metal conductive layer to a blackening treatment to form a blackening treatment layer on at least a part of a surface of the metal conductive layer.

25. A process as defined in claim 24, wherein the blackening treatment is carried out by subjecting the metal of the metal conductive layer to an oxidation treatment or an sulfurization treatment.

26. A light transmissive electoromagnetic shielding material prepared by the process described in any of claims 1 to 25.

27. A display filter comprising the light transmissive electoromagnetic shielding material described in claim 26.
